# EUROPÄISCHE PATENTANMELDUNG

(11) **EP 1 906 191 A2**
(43) Veröffentlichungstag der Anmeldung: **02.04.2008**
(21) Anmeldenummer: 07017052.7
(22) Anmeldetag: 31.08.2007
(51) Int. Cl.: G01R 19/25, H02M 5/257, H02J 3/18

(54) **Dreiphasige Schaltungsanordnung und Verfahren zum Betreiben der Schaltungsanordnung**

(30) Priorität: 28.09.2006 DE 202006014998 U
(71) Anmelder: AEG Power Supply Systems GmbH, 59581 Warstein-Belecke (DE)
(72) Erfinder: Hesse, Christian, 59581 Warstein (DE); Schaffarra, Christian, 59602 Rüthen (DE)
(74) Vertreter: Graefe, Jörg

(57) **Zusammenfassung**

Dreiphasige Schaltungsanordnung mit einer ersten Phase (L1), einer zweiten Phase (L2) und einer dritten Phase (L3) und mit zwei Stellgliedern (S1, S2), wobei an die Phasen (L1, L2, L3) zumindest eine Last (Z1, Z2, Z3) anschließbar ist und wobei zwei der drei Phasen (L1, L3) über je ein Stellglied (S1, S2) zum Einstellen der Spannung oder des Strom über der Last geführt sind, wobei die beiden über die Stellglieder (S1, S2) geführten Phasen (L1,L3) über je ein Messmittel (M1, M2) geführt sind, die zum Messen der Spannung bzw. des Stroms der zugeordneten Phasen (L1, L3) zu diskreten Abtastzeitpunkten von aufeinander folgenden Perioden geeignet und eingerichtet sind.

## Beschreibung

Die vorliegende Erfindung betrifft eine dreiphasige Schaltungsanordnung mit einer ersten Phase, einer zweiten Phase und einer dritten Phase und mit zwei Stellgliedern, wobei an die Phasen insbesondere in Stern- oder Dreiecksschaltung zumindest eine Last anschließbar ist und wobei zwei der drei Phasen über je ein Stellglied zum Einstellen der Spannung oder des Stroms über beziehungsweise durch die Last geführt sind. Die Erfindung betrifft ferner ein Verfahren zum Betreiben einer dreiphasigen Schaltungsanordnung, an deren drei Phasen eine oder mehrere Lasten anschließbar sind, wobei die Ströme beziehungsweise die Spannungen von zwei Phasen der drei Phasen gestellt und gemessen werden.

Aus dem Stand der Technik sind derartige Schaltungsanordnungen und Verfahren zum Betreiben dieser Schaltungsanordnungen bekannt. Derartige Schaltungsanordnungen werden auch als Drehstromsparschaltungen bezeichnet. Bei diesen bekannten Schaltungsanordnungen kann eine analoge Verbindung zwischen den beiden Leistungsteilen genutzt werden, um den nicht bekannten und nicht gemessenen Strom durch die weitere Phase durch eine als V-Schaltung bekannte Schaltung zu ermitteln. Dazu ist in den beiden gestellten Phasen jeweils ein Messwandler vorgesehen, die sekundärseitig in Reihe zu einem Widerstand gleicher Größe geschaltet sind. Die Reihenschaltungen aus der Sekundärseite des Messwandlers und den Widerständen sind einem dritten Widerstand gleicher Größe wie die ersten beiden Widerstände parallel geschaltet. An diesem dritten Widerstand wird ein Strom entsprechend des Stroms durch die zweite Phase erzeugt, der für eine weitere Verwendung, zum Beispiel eine Regelung oder Steuerung gemessen werden kann.

Die Schaltungsanordnung in V-Schaltung hat sich in der Praxis als sehr zuverlässig erwiesen. Leider ist die Erfassung des Stroms durch die weitere Phase recht aufwändig, da als Stellglieder keine Standardkomponenten vorgesehen werden können und besondere Messwandler vorgesehen werden müssen.

Hier setzt die vorliegende Erfindung an.

Der vorliegenden Erfindung liegt das Problem zugrunde, eine Schaltungsanordnung und ein Verfahren zum Betreiben einer derartigen Schaltungsanordnung vorzuschlagen, mit Hilfe derer der Strom oder die Spannung durch die nicht gestellte weitere Phase einer Drehstromsparschaltung ermittelt werden kann.

Dieses Problem wird erfindungsgemäß dadurch gelöst, dass die beiden, über die Stellglieder geführten Phase über je ein Messmittel geführt sind, die zum Messen der Spannung beziehungsweise des Stroms der zugeordneten Phasen zu diskreten Abtastzeitpunkten von aufeinanderfolgenden Perioden geeignet und eingerichtet sind. Dabei kann der Abtastzeitpunkt jeweils um einen Bruchteil einer Periodenlänge verschiebbar sein.

Die Abtastzeitpunkte werden vorteilhaft durch ein Mittel zum Steuern der Messmittel festgelegt. Neben dem Mittel zum Steuern der Messmittel kann die Schaltungsanordnung des Weiteren ein Mittel zum Auswerten der von den Messmitteln zu den Abtastzeitpunkten für die beiden Phasen gemessenen Messwerte aufweisen.

Das Auswertemittel kann bei einer ersten Variante einer erfindungsgemäßen Schaltungsanordnung zum Berechnen eines Wertes für die weitere Phase aus den Messwerten für die beiden Phasen geeignet und eingerichtet sein. Beispielsweise kann so ein Strom oder eine Spannung für die weitere Phase berechnet werden. Bei dieser Variante kann das Auswertemittel zum Feststellen eines Maximums einer vorgegebenen Anzahl von zeitlich nacheinander berechneten Werten der weiteren Phase geeignet und eingerichtet sein. So kann mit der Schaltungsanordnung aus den berechneten Werten das Maximum ermittelt werden. Das Auswertemittel kann weiter zum Berechnen eines Effektivwertes der Spannung oder des Stroms der weiteren Phase aus dem Maximum der berechneten Werte der weiteren Phase geeignet und eingerichtet sein.

Das Auswertemittel in einer zweiten Variante der erfindungsgemäßen Schaltungsanordnung kann zum Beispiel zum Feststellen eines Maximums einer vorgegebenen Anzahl von zeitlich nacheinander ermittelten Messwerten der beiden Phasen geeignet und eingerichtet sein. D. h. für jede Phase kann über eine bestimmte Folge von Perioden ein Maximum ermittelt werden.

Aus diesem ermittelten Maxima der Messwerte für die beiden Phasen kann dann bei der zweiten Variante vorteilhaft mit dem Auswertemittel ein Effektivwert für die Spannung beziehungsweise den Strom der beiden Phasen berechnet werden. Dazu muss lediglich die Spannungsform bekannt sein und der entsprechende Berechnungsfaktor (Formfaktor) bekannt sein, der den Zusammenhang zwischen einem Maximalwert und dem Effektivwert angibt. Dieser Formfaktor ist für eine sinusförmige Spannung √2. Sofern die Effektivwerte für die beiden gestellten Phasen berechnet sind, kann daraus bei bekannter Phasenverschiebung zwischen den einzelnen Phasen der Effektivwert für die weitere Phase berechnet werden.

Die Schaltungsanordnung ist aber insbesondere geeignet und eingerichtet bei sinusförmigen Spannungen betrieben zu werden.

Hinsichtlich des Verfahrens wird die Aufgabe erfindungsgemäß dadurch gelöst, dass zum Ermitteln der Spannung beziehungsweise des Stroms durch die weitere nicht gestellte Phase der Strom beziehungsweise die Spannung der beiden gestellten Phasen in aufeinanderfolgenden Perioden zu diskreten Abtastzeitpunkten gemessen wird. Vorteilhaft werden die Abtastzeitpunkte von Periode zu Periode um einen Bruchteil einer Periodenlänge, zum Beispiel 2° verschoben.

Vorzugsweise wird die Schaltungsanordnung im Vollschwingungstakt betrieben und zum Stellen werden ganze Schwingungen nicht durchgeschaltet.

Eine Verschiebung des nächsten Abtastzeitpunktes kann dann unterbleiben, wenn zum aktuellen Abtastzeitpunkt die Schwingung nicht durchgeschaltet wird. D. h., eine Verschiebung erfolgt immer nur dann, wenn die Schwingung, zu der der aktuelle Abtastzeitpunkt zugeordnet ist, durchgeschaltet ist.

Ein erfindungsgemäßes Verfahren kann so ausgestaltet sein, dass aus den Messwerten der beiden Phasen ein Wert für die weitere Phase berechnet wird. Aus einer Reihe von zeitlich hintereinander liegenden, so berechneten Werten kann dann ein Maximum bestimmt werden. Bei bekanntem Formfaktor kann daraus dann ein Effektivwert berechnet werden.

Ein erfindungsgemäßes Verfahren kann aber auch so ausgestaltet sein, dass aus den ermittelten Messwerten für jede der beiden gestellten Phasen ein Maximum ermittelt wird. Bei gegebener Spannungs- und Stromform und bei bekannter Winkellage der Phasen zueinander können Effektivwerte für die beiden Phasen und für die nicht gestellte Phase berechnet werden. Damit ist es auch möglich, die Leistung der Last zu ermitteln.

Ein Ausführungsbeispiel für eine erfindungsgemäße dreiphasige Schaltungsanordnung und ein Verfahren zum Betreiben dieser Schaltungsanordnung ist anhand der Zeichnung näher beschrieben.

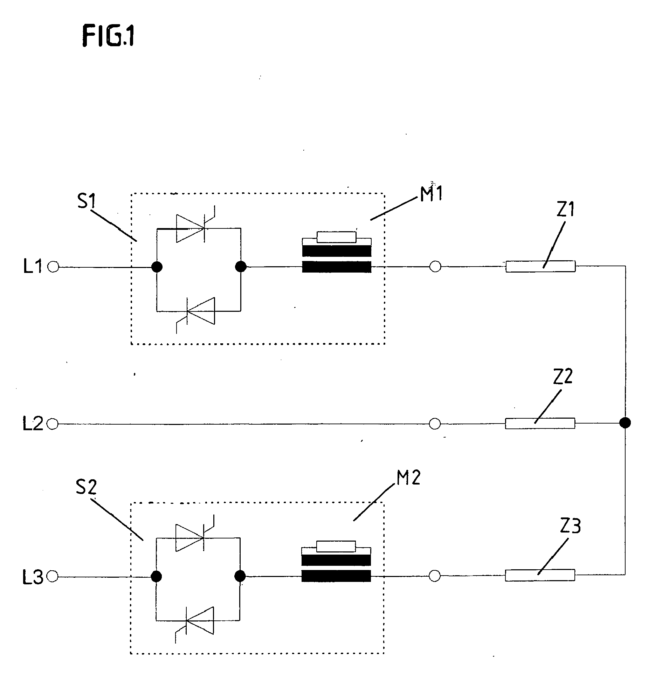

Es zeigt
- Fig. 1: ein Schaltbild einer erfindungsgemäßen Schaltungsanordnung und
- Fig. 2: ein Spannungs-Zeit-Diagramm zur Darstellung einer Abtastung einer Phase gemäß dem erfindungsgemäßen Verfahren.

Die erfindungsgemäße Schaltungsanordnung ist über drei Eingänge mit einem Spannungsversorgungsnetz verbunden. Über die drei Eingänge werden drei um 120° zueinander zeitlich versetzte Phasen sinusförmiger Spannung der Schaltungsanordnung zugeführt. An die drei Phasen L1, L2, L3 ist in Sternschaltung, eine Last Z1, Z2, Z3 angeschlossen. Zwei der drei Phasen, nämlich die erste und die dritte Phase L1 und L3 sind über ein Stellglied S1, S2 und ein Messmittel M1, M2 geführt. Mit den Stellgliedern kann die Spannungsversorgung der Last Z1, Z2, Z3 für den Zeitraum einer ganzen Periode unterbrochen werden, um die durchschnittlich von der Last Z1, Z2, Z3 aufgenommene Leistung einzustellen (Vollschwingungstakt).

Die Leistung der Last Z1, Z2, Z3 ergibt sich dabei aus dem Verhältnis der Anzahl der Perioden, zu denen die Last Z1, Z2, Z3 eingeschaltet ist (Einschaltzeit T_{S}), zum Verhältnis der insgesamt abgelaufenen Perioden (Taktperiodendauer T_{O}).

Eine derartige Schaltungsanordnung wird auch als Drehstromsparschaltung bezeichnet. Bei dieser Schaltungsart werden nur die beiden äußeren Phasen L1 und L3 gestellt, während die mittlere Phase ohne Stellglied verbleibt. Damit können die Kosten für die benötigten Leistungsteile um 1/3 gesenkt werden, da nur zwei statt drei Stellglieder benötigt werden.

Zur Ermittlung der an der Last umgesetzten Leistung werden die Ströme der ersten Phase L1 und der dritten Phase L3 erfasst. Aus diesen Strömen kann der Strom der zweiten Phase L2, die über kein Messmittel und kein Stellglied geführt wird, ermittelt werden. Die Messmittel M1, M2 sind dazu mit einem (nicht dargestellten) Steuer- und Auswertemittel verbunden. Die Verbindung erfolgt über einen Bus, wozu sowohl die Messmittel M1, M2 als auch das Steuer- und Auswertemittel digitale Schnittstellen aufweisen.

Theoretisch ist es möglich, die von den Messmitteln gemessenen Ströme laufend zu erfassen und an das Steuer- und Auswertemittel zu übertragen. Dieses führte jedoch zu einem erheblichen Datenverkehr auf dem Bus, was bei der vorgegebenen Bandbreite des Bussystems problematisch ist, da auch andere Informationen über den Bus übertragen werden.

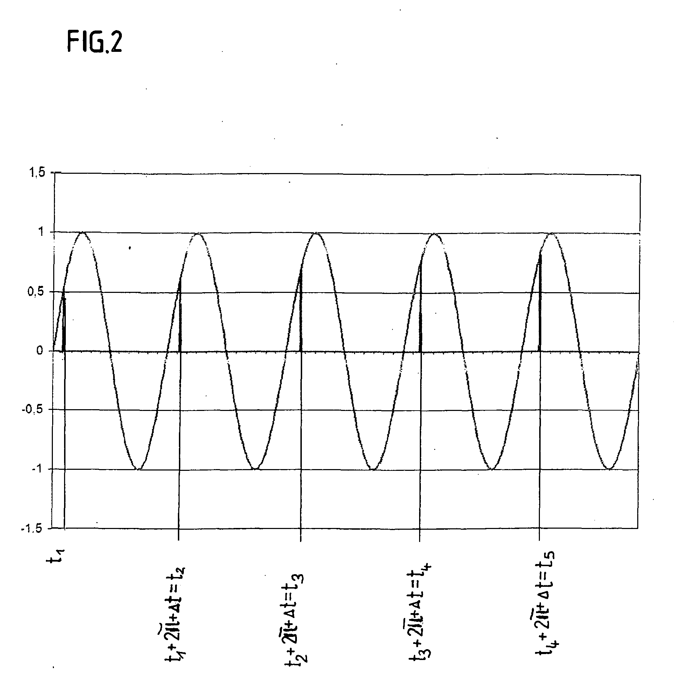

Zur Lösung dieses Problems wird die erfindungsgemäße Schaltungsanordnung so betrieben, dass nur zu einem diskreten Abtastzeitpunkt t₁, t₂, t₃, t₄, .. innerhalb einer Periode ein von den Messmitteln erfasster Messwert über den Bus an das Steuer- und Auswertemittel übermittelt wird. Der Zeitpunkt, zu welchem der Messwert an das Steuer- und Auswertemittel geliefert wird, wird durch das Steuer- und Auswertemittel durch eine entsprechende Anfrage an die Messmittel vorgegeben. In der nächsten Periode wird nun ein weiterer Messwert abgefragt. Der Abtastzeitpunkt liegt jedoch um einige Grad verschoben gegenüber dem Abtastzeitpunkt der vorhergehenden Periode. Die Verschiebung ist in Fig. 2 mit Δt gekennzeichnet.

Weitere Abfragen werden in den nachfolgenden Perioden gestartet, und zwar jeweils um Zeitpunkte t₂, t₃, t₄, die um Δt verschoben sind. Dadurch wird ein gesamter Abschnitt oder eine gesamte Periodendauer sukzessiv abgetastet, wobei die beanspruchte Bandbreite zur Übertragung der Messewerte sehr gering bleibt.

Aus den abgetasteten und übermittelten Messwerten wird durch das Steuer- und Auswertemittel ein Wert für die zweite Phase L2 berechnet. Anschließend wird jeweils ein Maximum der berechneten Werte (für L2) ermittelt, woraus bei bekannter Spannungsform der Effektivwert der zweiten Phase L2 berechnet werden kann. Somit liegen Effektivwerte für alle drei Phasen L1, L2, L3 vor. Sofern auch das Verhältnis der Einschaltzeit zur Taktperiodendauer bekannt ist, kann die Leistung der Last berechnet werden.

Eine derartige Ermittlung der Effektivwerte der weiteren Phase L2 ist nur dann möglich, wenn die Drehstromsparschaltung in der Betriebsart Vollschwingungstakt betrieben wird. Nur dann werden immer ganze Perioden des Netzstroms durchgeschaltet.

Grundsätzlich ist es möglich, das erfindungsgemäße Verfahren so durchzuführen, dass die Abtastung zeitversetzt von Periode zu Periode im Ergebnis jedoch über eine gesamte Periodendauer erfolgt. Dieses bedeutete jedoch, dass bis zum Vorliegen eines Berechnungswerts für den Strom beziehungsweise die Spannung der weiteren Phase L2 eine sehr lange Zeit vergeht. Bei einer Zeitverschiebung von Δt = 2° müssten 90 Perioden abgewartet werden, um sichergehen zu können, dass das Maximum erfasst wurde.

Ist jedoch die Art der Last bekannt - ist beispielsweise bekannt, dass es sich bei der Last um eine induktiv-ohmsche Last handelt - ist es ausreichend, wenn eine Abtastung zwischen 30° und 60° erfolgt. Bei einer jeweiligen Zeitverschiebung Δt der Abtastung von 2°, bedeutet dies, dass ein Ergebnis nach 15 Perioden vorliegt, vorausgesetzt, dass unter Volllast gefahren werden wird, d. h., dass während aller Perioden durchgeschaltet wird. Werden jedoch nicht alle Perioden durchgeschaltet, sondern wird zum Beispiel nur jede zweite Periode durchgeschaltet, wird also mit halber Leistung gefahren, muss der Zeitraum, der für die Erfassung des Effektivwerts der weiteren Phase L2 notwendig ist, verdoppelt werden. Statt 15 Perioden sind dann 30 Perioden erforderlich.

Könnte man sichergehen, dass ausschließlich rein ohmsche Lasten angeschlossen sind, wäre es ausreichend, wenn eine einzige Abfrage zum Zeitpunkt 30° erfolgt. Schon nach einer Periode wäre dann eine Berechnung des Effektivwerts für die weitere Phase L2 möglich.

## Patentansprüche

1. Dreiphasige Schaltungsanordnung mit einer ersten Phase (L1), einer zweiten Phase (L2) und einer dritten Phase (L3) und mit zwei Stellgliedern (S1, S2), wobei an die Phasen (L1, L2, L3) zumindest eine Last (Z1, Z2, Z3) anschließbar ist und wobei zwei der drei Phasen (L1, L3) über je ein Stellglied (S1, S2) zum Einstellen der Spannung oder des Strom über der Last geführt sind,
**dadurch gekennzeichnet,**
**dass** die beiden über die Stellglieder (S1, S2) geführten Phasen (L1, L3) über je ein Messmittel (M1, M2) geführt sind, die zum Messen der Spannung bzw. des Stroms der zugeordneten Phasen (L1, L3) zu diskreten Abtastzeitpunkten von aufeinander folgenden Perioden geeignet und eingerichtet sind.

2. Schaltungsanordnung nach Anspruch 1, **dadurch**
**gekennzeichnet, dass** der Abtastzeitpunkt jeweils um einen Bruchteil einer Periodenlänge (Δt) verschiebbar ist.

3. Schaltungsanordnung nach Anspruch 1 oder 2, **dadurch gekennzeichnet, dass** die Schaltungsanordnung ein Mittel zum Steuern der Messmittel (M1, M2) aufweist, die zum Festlegen der Abtastzeitpunkte geeignet und eingerichtet sind.

4. Schaltungsanordnung nach einem der Ansprüche 1 bis 3, **dadurch gekennzeichnet, dass** die Schaltungsanordnung ein Mittel zum Auswerten der von den Messmitteln (M1, M2) zu den Abtastzeitpunkten für die beiden Phasen (L1, L3) gemessenen Messwerte geeignet und eingerichtet.

5. Schaltungsanordnung nach Anspruch 4, **dadurch gekennzeichnet, dass** das Auswertemittel zum Berechnen eines Wertes für die weitere Phase (L2) aus den Messwerten für die beiden Phasen (L1, L3) geeignet und eingerichtet ist.

6. Schaltungsanordnung nach Anspruch 5, **dadurch gekennzeichnet, dass** das Auswertemittel zum Feststellen eines Maximums einer vorgegebenen Anzahl von zeitlich nacheinander berechneten Werten der weiteren Phase (L2) geeignet und eingerichtet ist.

7. Schaltungsanordnung nach Anspruch 6, **dadurch gekennzeichnet, dass** das Auswertemittel zum Berechnen eines Effektivwertes der Spannung bzw. des Stroms der weiteren Phasen (L2) aus dem Maximum der berechneten Werte der weiteren Phase (L2) geeignet und eingerichtet ist.

8. Schaltungsanordnung nach Anspruch 4, **dadurch gekennzeichnet, dass** das Auswertemittel zum Feststellen eines Maximums einer vorgegebenen Anzahl von zeitlich nacheinander ermittelten Messwerten der beiden Phasen (L1, L3) geeignet und eingerichtet ist.

9. Schaltungsanordnung nach Anspruch 8, **dadurch gekennzeichnet, dass** das Auswertemittel zum Berechnen eines Effektivwertes der Spannung bzw. des Stroms der beiden Phasen (L1, L3) aus den Maxima der Messwerte der beiden Phasen (L1, L3) geeignet und eingerichtet ist.

10. Schaltungsanordnung nach Anspruch 9, **dadurch gekennzeichnet, dass** das Auswertemittel zum Berechnen eines Effektivwertes der Spannung bzw. des Stroms der weiteren Phase (L2) geeignet und eingerichtet ist.

11. Schaltungsanordnung nach einem der Ansprüche 1 bis 10, **dadurch gekennzeichnet, dass** die Schaltungsanordnung zum Betrieb mit einer sinusförmigen Spannung geeignet und eingerichtet ist.

12. Verfahren zum Betreiben einer dreiphasigen Schaltungsanordnung an deren drei Phasen (L1, L2, L3) eine oder mehrere Lasten anschließbar sind, wobei die Ströme bzw. die Spannungen von zwei Phasen (L1, L3) der Phasen gestellt und gemessen werden,
**dadurch gekennzeichnet,**
**dass** zum Ermitteln der Spannung bzw. des Strom durch die weitere Phase (L2) der Spannung bzw. der Strom der beiden Phasen (L1, L3) in aufeinander folgenden Perioden zu diskreten Abtastzeitpunkten gemessen werden,

13. Verfahren nach Anspruch 12, **dadurch gekennzeichnet, dass** die Abtastzeitpunkte von Periode zu Periode um einen Bruchteil einer Periodelänge (Δt) verschoben werden.

14. Verfahren nach Anspruch 12 oder 13, **dadurch gekennzeichnet, dass** die Schaltungsanordnung im Vollschwingungstakt betrieben wird und zum Stellen ganze Schwingungen nicht durchgeschaltet werden.

15. Verfahren nach Anspruch 13 und 14, **dadurch gekennzeichnet, dass** eine Verschiebung des nächsten Abtastzeitpunktes nur erfolgt, wenn die Schwingung, der der aktuelle Abtastzeitpunkt zugeordnet ist, für die beiden Phasen (L1, L2) durchgeschaltet wurde.

16. Verfahren nach einem der Ansprüche 12 bis 15, **dadurch gekennzeichnet, dass** aus den ermittelten Messwerten der beiden Phasen (L1, L3) ein Wert für die weitere Phase (L2) berechnet wird.

17. Verfahren nach Anspruch 16, **dadurch gekennzeichnet, dass** den berechneten Werten für die weitere Phase (L2) ein Maximum ermittelt wird.

18. Verfahren nach Anspruch 17, **dadurch gekennzeichnet, dass** aus dem für die weitere Phase ermittelten Maximum ein Effektivwert berechnet wird.

19. Verfahren nach einem der Ansprüche 12 bis 15, **dadurch gekennzeichnet, dass** aus den ermittelten Messwerten für jede der beiden Phasen ein Maximum ermittelt wird.

20. Verfahren nach Anspruch 19, **dadurch gekennzeichnet, dass** aus den Maxima bei gegebener Spannungs- bzw. Stromform und bekannter Winkellage der Phasen zueinander Effektivwerte für die beiden Phasen (L1, L2) berechnet und daraus für die weitere Phase (L2) werden.

21. Verfahren nach Anspruch 18 und 20, **dadurch gekennzeichnet, dass** aus den Effektivwerten die Leistung der Last berechnet wird.
